# EUROPÄISCHE PATENTSCHRIFT

(11) **EP 0 764 344 B1**
(45) Veröffentlichungstag und Bekanntmachung des Hinweises auf die Patenterteilung: **04.03.1998**
(21) Anmeldenummer: 95923223.2
(22) Anmeldetag: 02.06.1995
(51) Int. Cl.: H01L 21/20

(54) **HALBZEUG FÜR EIN ELEKTRONISCHES ODER OPTO-ELEKTRONISCHES HALBLEITERBAUELEMENT**
SEMIFINISHED PRODUCT FOR ELECTRONIC OR OPTO-ELECTRONIC SEMICONDUCTOR COMPONENT
PRODUIT SEMI-FINI POUR COMPOSANT SEMI-CONDUCTEUR ELECTRONIQUE OU OPTOELECTRONIQUE

(30) Priorität: 09.06.1994 DE 4420024
(43) Veröffentlichungstag der Anmeldung: 26.03.1997
(73) Patentinhaber: Heraeus Quarzglas GmbH, D-63450 Hanau (DE)
(72) Erfinder: ENGLISCH, Wolfgang, D-65779 Kelkheim (DE); UEBBING, Reinhold, D-63755 Alzenau (DE)
(74) Vertreter: Staudt, Armin Walter
(86) Internationale Anmeldenummer: EP9502095
(87) Internationale Veröffentlichungsnummer: WO9534091

(56) Entgegenhaltungen:
- EP-A- 0 553 847
- JAPANESE JOURNAL OF APPLIED PHYSICS, Bd. 32, Nr. 1b, Januar 1993 TOKYO JP, Seiten 334-337, T. ABE ET AL. 'FABRICATION AND BONDING STRENGHTH OF BONDED SILICON-QUARTZ WAFERS.'
- EXTENDED ABSTRACTS, Bd. 93/1, 1993 PRINCETON, NEW JERSEY US, Seiten 1237-1238, K. EDA ET AL. 'QUARTZ CRYSTAL ON SILICON TECHNIQUE USING DIRECT BONDING '
- SENSORS AND ACTUATORS A, Bd. A21, Nr. 1/3, Februar 1990 LAUSANNE CH, Seiten 40-42, Q.-A.- HUANG ET AL. 'A NOVEL BONDING TECHNOLOGY FOR GaAs SENSORS.'
- PATENT ABSTRACTS OF JAPAN vol. 14 no. 143 (C-0703) ,19.März 1990 & JP,A,02 014840 (SHIN-ETSU CHEM CO LTD) 18.Januar 1990,
- PATENT ABSTRACTS OF JAPAN vol. 14 no. 171 (C-0706) ,3.April 1990 & JP,A,02 022134 (SHIN ETSU CHEM CO LTD) 25.Januar 1990,
- PATENT ABSTRACTS OF JAPAN vol. 8 no. 256 (E-280) ,22.November 1984 & JP,A,59 129421 (TOSHIBA CERAMICS) 25.Juli 1984,

## Beschreibung

Die Erfindung bezieht sich auf ein Halbzeug in Form eines Verbundkörpers für ein elektronisches oder opto-elektronisches Halbleiterbauelement, wobei der Verbundkörper aus einem scheibenförmigen, transparenten Quarzglas-Substrat aus synthetischem Quarzglas und einer Scheibe aus einem halbleitenden Material besteht und wobei direkt und großflächig miteinander verbundene Oberflächen des Quarzglas-Substrats und der Scheibe vor dem Verbinden miteinander poliert sind.

Aus "Japanese Journal of Applied Physics" Band 32, Nr. 1b, 1993, Seiten 334-337, T. Abe et al., "Fabrication and bonding strenghth of bonded silicon-quartz wafers" ist ein Verbundkörper für ein elektronisches Halbleiterbauelement bekannt, das aus einer Siliziumscheibe und einem Quarzglas-Substrat aus synthetischem Quarzglas besteht, das für Photomasken-Anwendungen benutzt wird. Das synthetische Quarzglas enthält OH-Gruppen in einer Konzentration von 500 ppm. Zur Erhöhung der Haftverbindung zwischen dem Quarzglas-Substrat und der Siliziumscheibe wird eine Behandlung des Verbundkörpers bei erhöhter Temperatur durchgeführt, beispielsweise jeweils 2 Stunden bei 300 °C und 450 °C, wobei nach der jeweiligen Temperaturbehandlung die Schichtdicke der Silizium-Scheibe vermindert wird.

Sowohl aus der EP-A-0 504 714 als auch aus dem US-Patent 4,883,215 ist ebenfalls ein Halbzeug in Form eines elektronischen oder opto-elektronischen Halbleiterbauelements bekannt, wobei der Verbundkörper aus einem scheibenförmigen, transparenten Quarzglas-Substrat und einer Scheibe aus einem halbleitenden Material besteht und wobei direkt und großflächig miteinander verbundene Oberflächen des Quarzglas-Substrats und der Scheibe vor dem Verbinden miteinander poliert sind. Dabei ist in dem US-Patent 4,883.215 angegeben, daß die miteinander verbundenen Oberflächen vor dem Verbinden spiegelpoliert sind, während in der genannten europäischen Patentanmeldung von "poliert" gesprochen wird. Die Scheiben werden mit den polierten Oberflächen aufeinander gelegt und durch Pressen miteinander verbunden. Nachträglich kann die Dicke der Scheibe aus halbleitendem Material durch chemische oder mechanische Behandlung stufenweise vermindert werden. Wie der EP-A-0 504 714 zu entnehmen ist, wird der Verbund der scheibenförmigen Körper durch Behandlung auf verschiedenen Temperaturstufen von einer temporären Verbindung (110 °C bis 350 °C) zu einer vollständigen Verbindung (250 °C bis 500 °C) geschaffen, wobei die Dicke der Scheibe aus halbleitendem Material nach jeder Zwischentemperaturstufe vermindert wird.

Aus "Patent Abstracts of Japan", vol. 8 no. 256 (E-280), 22. November 1984 & JP-A-59 129421 (Toshiba Ceramics) 25. Juli 1984, ist ein Quarzglas bekannt, das jeweils ≤ 0,05 ppm Na, K und Li und Cu enthält und eine Viskosität von ≥ 1.10¹¹ Pascalsekunde (10¹² Poise) bei 1200 °C besitzt. Dieses Quarzglas wird zur Wärmebehandlung von Halbleitern benutzt.

Aus "Patent Abstracts of Japan" vol. 14, no. 143 (C-0703), 19. März 1990 & JP-A-02 014840 (Shin-Etsu Chem Co Ltd), 18. Januar 1990, ist eine Grundplatte für Displays auf Basis eines Flüssigkristalls oder Elektrolumineszenz bekannt. Die Grundplatte besteht aus synthetischem Quarzglas, wobei der Rohstoff nach einem Sol-Gel-Verfahren gewonnen wird. Dieser Rohstoff wird durch Erhitzen in Cristoballit-Körnung überführt, die nach Dehydrierung zu Quarzglas eingeschmolzen wird. Dieses so hergestellte synthetische Quarzglas enthält ≤ 100 ppm OH-Gruppen, ≤ 10 ppm Cl und besitzt eine Viskosität von ≥ 5.10¹¹ Pascalsekunde (5 x 10¹² Poise) bei 1200°C.

Die bekannten Verbundkörper-Halbzeuge können jedoch den gestellten Anforderungen der Halbleitertechnik nicht genügen, denn wie aus der EP-A-0 504 714 bekannt ist, erfolgt eine extreme Verminderung der Haftkräfte zwischen den Scheiben, wenn der Verbundkörper beispielsweise einer Temperatur von nur 700 °C für zwei Stunden ausgesetzt wird. Zumindest teilweises Abplatzen der Scheiben voneinander sowie ein störendes Verbiegen des Verbundkörpers können daher nicht vermieden werden.

Aufgabe der Erfindung ist es, Halbzeuge gemäß dem Oberbegriff von Anspruch 1 bereitzustellen, die auch Temperaturen von oberhalb 900 °C, wie sie beispielsweise bei der Herstellung von Halbleiterschaltungen in wirtschaftlich realistischer Zeit zur Anwendung gelangen, standhalten, ohne daß befürchtet werden muß, daß eine wesentliche Minderung der Haftkräfte eintritt oder gar ein Abplatzen der Scheiben voneinander oder ein unerwünschtes Verbiegen des Verbundkörpers erfolgt.

Gelöst wird diese Aufgabe für eine Halbzeug gemäß dem Oberbegriff von Anspruch 1 erfindungsgemäß dadurch, daß das synthetische Quarzglas des Substrats eine Viskosität von wenigstens 1.10¹³ Pascalsekunde (10^{14,0} Poise) bei 950 °C aufweist, die bei einer Temperatur von 1050 °C einen Wert von 1.10¹¹ Pascalsekunde (10¹² Poise) nicht unterschreitet, daß der Gehalt an Alkali-Elementen im Quarzglas insgesamt höchstens 1 ppm beträgt, daß das Quarzglas an metallischen Verunreinigungen aus den Elementen Eisen, Nickel, Kupfer, Chrom und/oder der Übergangsmetalle insgesamt höchstens 1 ppm enthält, und daß wenigstens eine der polierten Oberflächen eine Rauhtiefe R_{q} von maximal 2 nm aufweist.

Unter der Rauhtiefe R_{q} wird der quadratische Mittelwert der gemessenen Profilhöhe innerhalb der Einzelmeßstrecke verstanden. Bevorzugt beträgt die Rauhtiefe R_{q} der polierten Oberflächen weniger als 1 nm. Als vorteilhaft hat sich erwiesen, ein Quarzglas-Substrat für den Verbundkörper zu verwenden, dessen polierte Oberfläche eine Rauhtiefe R_{q} von maximal 0,5 nm aufweist.

Bei erfindungsgemäßen Halbzeugen konnten selbst nach einer Temperaturbehandlung von zwei Stunden bei 950 °C keine wesentliche Verformung, wie insbesondere Durchbiegungen oder Krümmungen, festgestellt werden. Dies ist vermutlich darauf zurückzuführen, daß das ausgewählte Quarzglas für den mechanisch stabilisierenden Teil des Verbundkörpers auf Grund seiner hohen Viskosität derartig hohen Temperaturbelastungen, wie sie beispielsweise bei der Herstellung eines Isolationsoxides in einer SiliziumSchicht zur Anwendung gelangen, standhält ohne sich dabei wesentlich mechanisch zu deformieren. Auch ein Lösen des Quarzglas-Substrats von der Scheibe aus halbleitendem Material konnte nicht beobachtet werden. Die vorzügliche Haftfestigkeit des Verbundes ist dadurch gewährleistet, daß die großflächig miteinander zu verbindenden, polierten Oberflächen des Quarzglas-Substrats und des halbleitenden Materials derart poliert sind, daß wenigstens eine davon eine Rauhtiefe R_{q} von maximal 2 nm aufweist. Eine deutliche Verbesserung der Haftfestigkeit ergibt sich, wenn die Rauhtiefe R_{q} der polierten Oberfläche des Quarzglas-Substrats maximal 0,5 nm beträgt.

Durch den geringen Gehalt des verwendeten Quarzglases an Alkali-Elementen ist sichergestellt, daß das halbleitende Material nicht durch Eindiffundieren solcher Elemente in seinen halbleitenden Eigenschaften negativ beeinflußt wird.

Durch die Reinheit des Quarzglases, wie sie in den Ansprüchen 1 und 4 charakterisiert ist, ist gewährleistet, daß bei der Weiterverarbeitung des Halbzeugs zu elektronischen Halbleiterbauelementen, wie zum Beispiel Halbleiterspeicher (RAM, DRAM), Mikroprozessoren oder Transistoren, wenn die Scheibe des halbleitenden Materials aus dotiertem Silizium besteht, oder zu opto-elektronischen Bauelementen, wie zum Beispiel TFT-LCDs (thin film transistor liquid crystal displays = Dünn-Film-Transistor-Flüssig-Kristall-Displays), wenn die Scheibe des halbleitenden Materials aus dotiertem Silizium besteht, keine die elektronischen Eigenschaften des halbleitenden Materials nachteilig verändernden Stoffe durch beispielsweise Diffusion in das dotierte Silizium gelangen können. Anstelle von Scheiben aus dotiertem Silizium als halbleitendes Material können insbesondere zur Herstellung opto-elektronischer Bauelemente auch Scheiben aus dotierem Gallium-Arsenid, Gallium-Phosphid, Gallium-Aluminium-Arsenid oder Gallium-Nitrid zur Herstellung erfindungsgemäßer Halbzeuge verwendet werden.

Die Dicke des Quarzglas-Substrats beträgt vorteilhafterweise weniger als 10 mm; bevorzugt liegt sie unterhalb von 2 mm.

Für die Weiterbearbeitung des erfindungsgemäßen Halbzeugs zu elektronischen oder opto-elektronischen Halbleiterbauelementen hat es sich bewährt, beim fertigen Verbundkörper die Scheibe aus halbleitendem Material durch Abtragen zu vermindern, vorteilhafterweise auf eine Dicke von maximal 5000 nm. Hierdurch wird der halbleitende Teil des Verbundkörpers auf eine optimale Schichtdicke reduziert. Eine nachfolgende Dotierung kann sowohl in der ganzen Fläche über die gesamte Schichtdicke des halbleitenden Materials vorliegen als auch in diskreten Bereichen. Der Siliziumdioxid-Gehalt des Halbzeugs mit verminderter Schichtdicke von maximal 5000 nm an halbleitendem Material beträgt mindestens 99,2 %. Zur Verminderung der Schichtdicke des halbleitenden Materials eignen sich aus der Halbleitertechnik an sich bekannte mechanische Verfahren. Wenn die Schichtdicke des halbleitenden Materials sehr dünn gemacht werden soll, beispielsweise auf eine Dicke unterhalb 200 nm abgetragen werden soll, kann hierzu ein Plasmaverfahren benutzt werden, wie es beispielsweise von der Firma Hughes Danbury Optical Systems Inc., Danbury (Connecticut), USA, kommerziell zum Dünnen von scheibenförmigen Körpern angeboten wird.

Anhand des nachfolgenden Ausführungsbeispiels wird die Herstellung eines erfindungsgemäßen Halbzeugs beschrieben.

Als halbleitendes Material wurde eine handelsübliche, mit Bor dotierte Scheibe aus einkristallinem Reinstsilizium (Kristallorientierung <100>) verwendet, deren Durchmesser 150 mm betrug und die eine Dicke von 675 µm aufwies. Die Scheibe war kantenverrundet, ihre Planität war ≤ 30 µm, ihre Gesamtdickenschwankung war ≤ 6 µm.

Das Quarzglas-Substrat bestand aus transparentem, synthetischem Quarzglas, dessen Viskosität bei einer Temperatur von 950 °C einen Wert von 1.10^{13,5} Pascalsekunde (10^{14,5} Poise) aufwies. Der OH-Gehalt des Quarzglases lag unter 1 ppm. Das scheibenförmige Quarzglas-Substrat hatte einen Durchmesser von 152 mm, seine Dicke betrug 800 µm, es war kantenverrundet, es besaß eine Planität von ≤ 2 µm, die Gesamtdickenschwankung war ≤ 2 µm. Das Quarzglas-Substrat war beidseitig poliert, wobei die Rauhtiefe R_{q} jeder polierten Oberfläche 0,45 nm betrug. Der Gesamtgehalt an Alkali-Elementen lag bei ≤ 0,1 ppm.

Bevor die beiden scheibenförmigen Körper miteinander verbunden wurden, wurden sie gereinigt. Hierzu wurde die Silizium-Scheibe nach dem bekannten RCA-Verfahren (Handbook of Semiconductor Silicon Technology, Noyes Publications, New Jersey, USA 1990, S. 275 ff.) behandelt. Das Quarzglas-Substrat wurde zunächst mit Äthylalkohol (MOS selectipur) vorgereinigt, danach einer Behandlung mit einer 30%-igen Salzsäure (Ultrapur) für eine Dauer von 10 Minuten unterzogen und anschließend mit höchstreinem Wasser (0,1 µS/cm) gespült.

Nach der Reinigung wurden die miteinander zu verbindenden Körper in einem Reinstraum übereinander angeordnet, vorzugsweise das Quarzglas-Substrat über der Silizium-Scheibe. Leichter Druck auf die obenliegende Scheibe führte zu einer innigen Verbindung beider Körper miteinander. Die Qualität der Verbindung wurde durch das transparente Quarzglas anhand des Interferenzmusters begutachtet und läßt sich auf diese Weise gut kontrollieren.

Das so hergestellte Halbzeug in Form eines Verbundkörpers wies mechanische Spannungen von weniger als 1000 N/cm² auf. Für die Elektronenbeweglichkeit in der einkristallinen Silizium-Scheibe wurde bei Raumtemperatur ein Wert von mehr als 100 cm²/V/s gemessen.

Anschließend wurde die Dicke der mit dem Quarzglas-Substrat verbundenen Silizium-Scheibe durch mechanisches Abtragen von ihrer Ausgangsdicke von 675 µm auf eine Dicke von 2000 nm vermindert.

In den Figuren 1 bis 3 sind Beispiele erfindungsgemäßer Halbzeuge dargestellt. Es zeigen:
- Figur 1: Eine perspektivische Ansicht eines Halbzeugs.
- Figur 2: Einen Vertikalschnitt durch ein Halbzeug.
- Figur 3: Einen Vertikalschnitt durch ein Halbzeug.

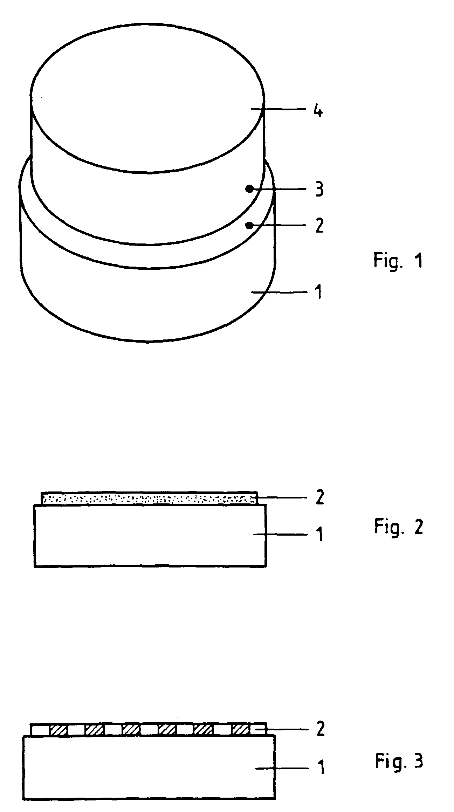

Das Halbzeug gemäß Figur 1 besteht aus einem scheibenförmigen, transparenten Quarzglas-Substrat 1, dessen polierte Oberfläche 2 ganzflächig mit der polierten Oberfläche 3 einer Silizium-Scheibe 4 direkt verbunden ist. Die Abmessungen des Quarzglas-Substrates und der Silizium-Scheibe sowie deren Planität und Gesamtdickenschwankung entsprechen den im Ausführungsbeispiel angegebenen Werten. Die Viskosität des Quarzglas-Substrates betrug hier 1.10^{13,5} Pascalsekunde (10^{14,5} Poise) bei 950 °C, sein OH-Gehalt lag unter 1 ppm, sein Gesamtgehalt an Alkali-Elementen betrug ≤ 0,1 ppm.

Figur 2 zeigt ein Halbzeug mit Quarzglas-Substrat 1 und Silizium-Scheibe 2. Bei diesem Halbzeug ist die ursprüngliche Dicke der Silizium-Scheibe 2 nach Herstellung des Verbundkörpers durch mechanisches Abtragen auf eine Dicke von 2000 nm vermindert. Danach wurde die dicken-verminderte Silizium-Scheibe über ihre gesamte Schichtdicke, wie durch Punktierung angedeutet, mit Arsen, wie in der Halbleitertechnik üblich, dotiert.

Das in Figur 3 dargestellte Halbzeug aus Quarzglas-Substrat 1 und Silizium-Scheibe 2 unterscheidet sich von dem in Figur 2 dargestellten dadurch, daß bei einer nach ihrer Dickenverminderung auf maximal 1000 nm Dicke vorliegenden Silizium-Scheibe diskrete, nicht aneinandergrenzende Flächenbereiche über ihre darunter liegende, gesamte Schichtdicke, wie durch Schraffierung angedeutet, mit Arsen, wie in der Halbleitertechnik üblich, dotiert sind.

## Patentansprüche

1. Halbzeug in Form eines Verbundkörpers für ein elektronisches oder opto-elektronisches Halbleiterbauelement, wobei der Verbundkörper aus einem scheibenförmigen, transparenten Quarzglas-Substrat (1) aus synthetischem Quarzglas und einer Scheibe (4) aus einem halbleitenden Material besteht und wobei direkt und großflächig miteinander verbundene Oberflächen (2, 3) des Quarzglas-Substrats (1) und der Scheibe (4) vor dem Verbinden miteinander poliert sind, dadurch gekennzeichnet, daß das synthetische Quarzglas des Substrats (1) eine Viskosität von wenigstens 1.10¹³ Pascalsekunde (10^{14,0} Poise) bei 950 °C aufweist, die bei einer Temperatur von 1050 °C einen Wert von 10¹² Poise nicht unterschreitet, daß der Gehalt an Alkali-Elementen im Quarzglas insgesamt höchstens 1 ppm beträgt, daß das Quarzglas an metallischen Verunreinigungen aus den Elementen Eisen, Nickel, Kupfer, Chrom und/oder der Übergangsmetalle insgesamt höchstens 1 ppm enthält, und daß wenigstens eine der polierten Oberflächen (2, 3) eine Rauhtiefe R_{q} von maximal 2 nm aufweist.

2. Halbzeug nach Anspruch 1, dadurch gekennzeichnet, daß wenigstens eine der polierten Oberflächen eine Rauhtiefe R_{q} von weniger als 1 nm aufweist.

3. Halbzeug nach den Ansprüchen 1 oder 2, dadurch gekennzeichnet, daß die Rauhtiefe R_{q} der polierten Oberfläche des Quarzglas-Substrats maximal 0,5 nm beträgt.

4. Halbzeug nach einem der Ansprüche 1 bis 3, dadurch gekennzeichnet, daß das Quarzglas einen Gehalt von insgesamt höchstens 1 ppm der Elemente Phosphor, Arsen, Antimon, Wismut, Bor, Gallium, Indium und/oder Titan aufweist.

5. Halbzeug nach einem oder mehreren der Ansprüche 1 bis 4, dadurch gekennzeichnet, daß der OH-Gehalt des Quarzglases höchstens 1 ppm beträgt.

6. Halbzeug nach einem oder mehreren der Ansprüche 1 bis 5, dadurch gekennzeichnet, daß das Quarzglas-Substrat eine Dicke von ≤ 10 mm aufweist.

7. Halbzeug nach Anspruch 6, dadurch gekennzeichnet, daß die Dicke des Quarzglas-Substrats unterhalb 2 mm liegt.

8. Halbzeug nach einem oder mehreren der Ansprüche 1 bis 7, dadurch gekennzeichnet, daß das halbleitende Material aus einkristallinem Silizium besteht.

9. Halbzeug nach einem oder mehreren der Ansprüche 1 bis 7, dadurch gekennzeichnet, daß das halbleitende Material aus einkristallinem Gallium-Arsenid, Gallium-Phosphid, Gallium-Aluminium-Arsenid oder Gallium-Nitrid besteht.

10. Halbzeug nach den Ansprüchen 8 oder 9, dadurch gekennzeichnet, daß das halbleitende Material dotiert ist.

11. Halbzeug nach einem oder mehreren der Ansprüche 1 bis 10, dadurch gekennzeichnet, daß die Scheibe aus halbleitendem Material durch Abtragen vermindert ist.

12. Halbzeug nach Anspruch 11, dadurch gekennzeichnet, daß die Scheibe aus halbleitendem Material durch Abtragen auf eine Dicke von maximal 5000 nm vermindert ist.

13. Halbzeug nach Anspruch 12, dadurch gekennzeichnet, daß bei einer Dicke von maximal 5000 nm die Scheibe aus halbleitendem Material über ihre gesamte Schichtdicke dotiert ist.

14. Halbzeug nach Anspruch 12, dadurch gekennzeichnet, daß bei einer Schichtdicke von maximal 1000 nm diskrete, nicht aneinandergrenzende Flächenbereiche der Scheibe aus halbleitendem Material über ihre darunter liegende gesamte Schichtdicke dotiert sind.

15. Halbzeug nach einem der Ansprüche 12 bis 14, dadurch gekennzeichnet, daß der Silizium-Dioxid-Gehalt des Verbundkörpers mindestens 99,2 % beträgt.

## Claims

1. Semifinished product in the form of a composite body for an electronic or optoelectronic semiconductor component, wherein the composite body consists of a disc-shaped transparent quartz glass substrate (1) of synthetic quartz glass and of a disc (4) of a semiconducting material and wherein surfaces (2,3) of the quartz glass substrate (1), which are connected with each other directly and over a large area, and of the disc (4) are polished before being connected with each other, characterised in that the synthetic quartz glass of the substrate (1) has a viscosity of at least 1.10¹³ Pascal seconds (10^{14.0} Poise) at 950°C, which at a temperature of 1050°C does not fall below a value of 10¹² Poise, that the content of alkali elements in the quartz glass in total amounts to a maximum of 1 ppm, that the quartz glass contains in total a maximum of 1 ppm of metallic impurities from the elements iron, nickel, copper, chromium and/or the transition metals, and that at least one of the polished surfaces (2,3) has a roughness depth R_{q} of a maximum 2 nm.

2. Semifinished product according to claim 1, characterised in that at least one of the polished surfaces has a roughness depth R_{q} of less than 1 nm.

3. Semifinished product according to claims 1 or 2, characterised in that the roughness depth R_{q} of the polished surface of the quartz glass substrate amounts to a maximum of 0.5 mm.

4. Semifinished product according to one of claims 1 to 3, characterised in that the quartz glass has a content of in total a maximum of 1 ppm of the elements phosphorus, arsenic, antimony, bismuth, boron, gallium, indium and/or titanium.

5. Semifinished product according to one or more of claims 1 to 4, characterised in that the OH content of the quartz glass amounts to a maximum of 1 ppm.

6. Semifinished product according to one or more of claims 1 to 5, characterised in that the quartz glass substrate has a thickness of ≤ 10 mm.

7. Semifinished product according to claim 6, characterised in that the thickness of the quartz glass substrate lies below 2 mm.

8. Semifinished product according to one or more of claims 1 to 7, characterised in that the semiconducting material consists of monocrystalline silicon.

9. Semifinished product according to one or more of claims 1 to 7, characterised in that the semiconducting material consists of monocrystalline gallium arsenide, gallium phosphide, gallium aluminium arsenide or gallium nitride.

10. Semifinished product according to claims 8 or 9, characterised in that the semiconducting material is doped.

11. Semifinished product according to one or more of claims 1 to 10, characterised in that the disc of semiconducting material is reduced by abrasion.

12. Semifinished product according to claim 11, characterised in that the disc of semiconducting material is reduced by abrasion to a thickness of a maximum of 5000 nm.

13. Semifinished product according to claim 12, characterised in that with a thickness of a maximum of 5000 nm, the disc of semiconducting material is doped over its entire layer thickness.

14. Semifinished product according to claim 12, characterised in that with a layer thickness of a maximum of 1000 nm, discrete surface areas of the disc of semiconducting material, not adjoining each other, are doped over their entire layer thickness lying therebelow.

15. Semifinished product according to one of claims 12 to 14, characterised in that the silicon dioxide content of the composite body amounts to at least 99.2%.

## Revendications

1. Produit semi-fini sous la forme d'un corps composite pour un composant semiconducteur électronique ou opto-électronique, le corps composite se composant d'un substrat de verre de quartz transparent sous forme de disque (1) en verre de quartz synthétique et d'un disque (4) en un matériau semiconducteur et des surfaces (2, 3) réunies directement et de surface étendue du substrat de verre de quartz (1) et du disque (4) étant polies avant la réunion de celles-ci, caractérisé en ce que le verre de quartz du substrat (1) présente une viscosité d'au moins 1.10¹³ Pascal-seconde (10^{14,0} Poise) à 950°C, qui ne descend pas au-dessous à une température de 1050°C à une valeur de 10¹² Poise, en ce que la teneur en éléments alcalins dans le verre de quartz s'élève globalement au plus à 1 ppm, en ce que le verre de quartz contient en tant qu'impuretés métalliques des éléments fer, nickel, cuivre, chrome et/ou des métaux de transition en tout au plus 1 ppm, et en ce qu'au moins une des surfaces polies (2, 3) présente une rugosité superficielle Rq de 2 nm au maximum.

2. Produit semi-fini selon la revendication 1, caractérisé en ce qu'au moins une des surfaces polies présente une rugosité superficielle R_{q} inférieure à 1 nm.

3. Produit semi-fini selon les revendications 1 ou 2, caractérisé en ce que la rugosité superficielle R_{q} des surfaces polies du substrat de verre de quartz s'élève au maximum à 0,5 nm.

4. Produit semi-fini selon l'une quelconque des revendications 1 à 3, caractérisé en ce que le verre de quartz présente une teneur globale au maximum de 1 ppm des éléments phosphore, arsenic, antimoine, bismuth, bore, gallium, indium et/ou titane.

5. Produit semi-fini selon l'une ou plusieurs des revendications 1 à 4, caractérisé en ce que la teneur en OH du verre de quartz s'élève au maximum à 1 ppm.

6. Produit semi-fini selon l'une ou plusieurs des revendications 1 à 5, caractérisé en ce que le substrat de verre de quartz présente une épaisseur ≤ 10 nm.

7. Produit semi-fini selon la revendication 6, caractérisé en ce que l'épaisseur du substrat de verre de quartz se trouve au-dessous de 2 mm.

8. Produit semi-fini selon l'une ou plusieurs des revendications 1 à 7, caractérisé en ce que le matériau semiconducteur est en silicium monocristallin.

9. Produit semi-fini selon l'une ou plusieurs des revendications 1 à 7, caractérisé en ce que le matériau semiconducteur est en arséniure de gallium, en phosphure de gallium, en arséniure d'aluminium-gallium ou en nitrure de gallium monocristallin.

10. Produit semi-fini selon les revendications 8 ou 9, caractérisé en ce que le matériau semiconducteur est dopé.

11. Produit semi-fini selon l'une ou plusieurs des revendications 1 à 10, caractérisé en ce que le disque en matériau semiconducteur est réduit par enlèvement de matière.

12. Produit semi-fini selon la revendication 11, caractérisé en ce que le disque en matériau semiconducteur est réduit par enlèvement de matière à une épaisseur de 5000 nm au maximum.

13. Produit semi-fini selon la revendication 12, caractérisé en ce que, dans le cas d'une épaisseur de 5000 nm au maximum, le disque en matériau semiconducteur est dopé sur toute son épaisseur de couche.

14. Produit semi-fini selon la revendication 12, caractérisé en ce que, dans le cas d'une épaisseur de couche de 1000 nm au maximum, des zones superficielles discrètes, non adjacentes du disque en matériau semiconducteur sont dopées sur la totalité de l'épaisseur de couches sous-jacentes.

15. Produit semi-fini selon l'une des revendications 12 à 14, caractérisé en ce que la teneur en dioxyde de silicium du corps composite s'élève au minimum à 99,2%.
